# EUROPEAN PATENT APPLICATION

(11) **EP 2 824 089 A1**
(43) Date of publication of application: **14.01.2015**
(21) Application number: 14772650.9
(22) Date of filing: 27.02.2014
(51) Int. Cl.: C04B 35/443, C03C 14/00, C04B 35/10, C04B 35/44, H05K 1/03

(54) **GLASS/CERAMIC COMPOSITE MATERIAL**

(30) Priority: 26.03.2013 JP 2013064772
(71) Applicant: NGK Insulators, Ltd., Nagoya-city, Aichi 467-8530 (JP)
(72) Inventor: YANO, Shinsuke, Aichi 467-8530 (JP); TANAKA, Yoshihiro, Aichi 467-8530 (JP); YAMAGUCHI, Hirofumi, Aichi 467-8530 (JP)
(74) Representative: Naylor, Matthew John
(86) International application number: PCT/JP2014/054878
(87) International publication number: WO 2014/156457

(57) **Abstract**

In a glass-ceramics composite comprising a glass phase and a crystalline phase which contains an oxide system ceramics dispersed in the glass phase, by making the composition of material which forms the glass phase meet specific conditions, the thermal conductivity of the glass-ceramics composite which is obtained by firing the glass phase and the crystalline phase is raised. Thereby, a glass-ceramics composite which is suitable for a low-temperature firing use and has a high thermal conductivity is provided.

## Description

### [Technical Field]

The present invention relates to a glass-ceramics composite. More particularly, the present invention relates to a glass-ceramics composite which is suitable for a low-temperature firing use and has a high thermal conductivity.

### [Background Art]

For example, in a wiring substrate applied to a semiconductor package, a multi-layer wiring substrate, etc., it has been an important subject to suppress loss due to reduction in electrical resistance of conductor which constitutes wiring and improve heat-resistance corresponding to increase in heat which generates from a semiconductor device. As countermeasures to the former, for example, metal (good conductor) which has low electrical resistance, such as gold, silver, copper, and alloys containing any of these metals, is widely used as the conductor. On the other hand, as countermeasures to the latter, in place of resin substrate which uses resin as base material, ceramic substrate which uses ceramics as base material is widely used.

In such ceramic substrate, as mentioned above, the conductor which constitutes a surface electrode and inner-layer wiring contains good conductor, such as gold, silver, copper, and alloys containing any of these metals, for example. Thereby, in such ceramic substrate, even in a case where inner-layer wiring highly fine-lined , for example, for the purpose of attaining higher performance of a semiconductor package, etc., increase in electrical resistance of wiring can be suppressed to reduce the resistive loss in a semiconductor package which uses the ceramic substrate.

By the way, the metals (low-resistance metals) such as gold, silver, copper, and alloys containing any of these metals, which have low electrical resistances and are used for the purpose of suppressing increase in electrical resistance of wiring as mentioned above, have relatively low melting points, as compared with other metals. When sheet of dielectric material (base material comprising a dielectric layer), in which a conductive pattern (wiring) comprising such a low-resistance metal is embedded, is co-fired at a temperature of the melting point of the metal or higher, there is a possibility that the metal may melt and it may become difficult to maintain a desired shape of the conductive pattern. Therefore, when such low-resistance conductor is used as conductor which constitutes the surface electrode and inner-layer wiring, it is desirable to use ceramics which can be fired at a temperature less than the melting point of the low-resistance conductor used.

In addition, as ceramics which can be fired at a temperature less than the melting point of the low-resistance conductor used, as mentioned above, it is desirable to use what is called a "low-temperature co-fired substrate material (LTCC: Low Temperature Co-fired Ceramics)." Moreover, as LTCC, for example, a glass-ceramics composite with its firing temperature lowered by blending a glass component with ceramics is generally used. By using such a glass-ceramics composite as LTCC, even when gold, silver, copper, or alloy containing any of these metals, etc., which is a low-resistance conductor with a relatively low melting point as mentioned above, is used as the conductor, the possibility that the metal may melt at the time of co-firing of the substrate and it may become difficult to maintain a desired shape of the conductive pattern.

As a specific example of a glass-ceramics composite suitable as LTCC as mentioned above, for example, a composite which comprises a glass-matrix and ceramic particles (filler particles) dispersed in the glass-matrix is known. Especially, as glass-ceramics composites suitable for substrate material with a wiring part comprising low-resistance metal (for instance, gold, silver, copper, and alloy containing any of these metals, etc.) therein, a variety of composites using alumina particle as the filler particles dispersed in the glass-matrix have been proposed in the art (for instance, refer to the patent literature PTL 1 to 4).

However, these LTCC's have a problem that thermal conductivities of these LTCC's become low since the thermal conductivity of the glass phase which constitutes a glass-ceramics composite is low. Specifically, the thermal conductivities of the above-mentioned LTCC's using glass are about 2 to 4 W/(°C•m), remarkably low, while the thermal conductivity of alumina substrate fired at a temperature higher than that for LTCC is about 15 W/(°C•m).

Then, in the art, in glass-ceramics composites, it has been proposed to attain a high thermal conductivity more than 4 W/(°C•m) by precipitating a crystal of celsian (BaAl₂Si₂O₈) which has a high aspect ratio (for instance, 3 or more) from a glass phase (for instance, refer to the patent literature PTL 4). However, a shape of a crystal which precipitates from a glass phase is affected not only by a composition of glass, but also by a variety of factors, for example, such as a particle size of glass (particle size of the glass powder which is mixed and fired with ceramic particles (filler particles) to be a glass-ceramics composite) and firing conditions. Therefore, in order to precipitate a celsian crystal which has such a high aspect ratio, it is necessary to strictly control these various factors. Accordingly, it is thought that it is difficult to produce stably a glass-ceramics composite which has a high thermal conductivity by precipitating a celsian crystal having a high aspect ratio from a glass phase.

As mentioned above, in the art, there has been a continuous demand to a technology which can easily obtain a glass-ceramics composite which is suitable for a low-temperature firing use and has a high thermal conductivity.

### [Citation List]

### [Patent Literature]

[PTL 1] Japanese Patent Application Laid-Open (kokai) No. S62-113758
[PTL 2] Japanese Patent Application Laid-Open (kokai) No. H04-275975
[PTL 3] Japanese Patent Application Laid-Open (kokai) No. H07-135379
[PTL 4] Japanese Patent No. 5057620

### [Summary of Invention]

### [Technical Problem]

As mentioned above, in the art, there has been a continuous demand to a technology which can easily obtain a glass-ceramics composite which is suitable for a low-temperature firing use and has a high thermal conductivity. The present invention has been conceived in order to meet such a demand. More specifically, the present invention has one objective to provide a glass-ceramics composite which is suitable for a low-temperature firing use and has a high thermal conductivity.

### [Solution to Problem]

The above-mentioned one objective of the present invention is attained by a glass-ceramics composite, which is obtained by firing;
a glass phase obtained from a glass material containing silicon dioxide (SiO₂), aluminum oxide (Al₂O₃) and at least one of magnesium oxide (MgO) or zinc oxide (ZnO), and
a crystalline phase containing at least one sort of oxide system ceramics, wherein:
based on the total amount of said glass material,
   the combination ratio of silicon dioxide (SiO₂) is 45 mass % or more and 70 mass % or less,
   the combination ratio of aluminum oxide (Al₂O₃) is 16 mass % or more and 40 mass % or less, and
   the combination ratio of magnesium oxide (MgO) is 14 mass % or more or the combination ratio of zinc oxide (ZnO) is more than 0 mass %, and both of the combination ratio of magnesium oxide (MgO) and the combination ratio of zinc oxide (ZnO) are 38 mass % or less, and
based on the amount of sum totals of said glass phase and said crystalline phase,
   the combination ratio of said crystalline phase is 5 mass % or more and less than 50 mass %.

### [Advantageous Effects of Invention]

In accordance with the glass-ceramics composite according to the present invention, a glass-ceramics composite which is suitable for a low-temperature firing use and has a high thermal conductivity can be easily provided.

### [Description of Embodiments]

As mentioned above, the present invention has one objective to provide a glass-ceramics composite which is suitable for a low-temperature firing use and has a high thermal conductivity.

As a result of wholehearted research for achieving the above-mentioned objective, the inventor has found that, in a glass-ceramics composite comprising a glass phase and a crystalline phase which contains an oxide system ceramics dispersed in the glass phase, the thermal conductivity of the glass-ceramics composite which is obtained by firing the glass phase and the crystalline phase can be raised by making the composition of material which forms the glass phase meet specific conditions, and has conceived the present invention.

Namely, the first embodiment of the present invention is,
a glass-ceramics composite, which is obtained by firing;
a glass phase obtained from a glass material containing silicon dioxide (SiO₂), aluminum oxide (Al₂O₃) and at least one of magnesium oxide (MgO) or zinc oxide (ZnO), and
a crystalline phase containing at least one sort of oxide system ceramics, wherein:
based on the total amount of said glass material,
   the combination ratio of silicon dioxide (SiO₂) is 45 mass % or more and 70 mass % or less,
   the combination ratio of aluminum oxide (Al₂O₃) is 16 mass % or more and 40 mass % or less, and
   the combination ratio of magnesium oxide (MgO) is 14 mass % or more or the combination ratio of zinc oxide (ZnO) is more than 0 mass %, and both of the combination ratio of magnesium oxide (MgO) and the combination ratio of zinc oxide (ZnO) are 38 mass % or less, and
based on the amount of sum totals of said glass phase and said crystalline phase,
   the combination ratio of said crystalline phase is 5 mass % or more and less than 50 mass %.

As mentioned above, a glass-ceramics composite according to the present embodiment is a glass-ceramics composite, which is obtained by firing;
a glass phase obtained from a glass material containing silicon dioxide (SiO₂), aluminum oxide (Al₂O₃) and at least one of magnesium oxide (MgO) or zinc oxide (ZnO), and
a crystalline phase containing at least one sort of oxide system ceramics.

In the above-mentioned glass material, as for magnesium oxide (MgO) and zinc oxide (ZnO), only either of them may be contained, or both of them may be contained. Namely, when the above-mentioned glass material contains magnesium oxide (MgO), zinc oxide (ZnO) does not need to be contained therein. On the contrary, when the above-mentioned glass material contains zinc oxide (ZnO), magnesium oxide (MgO) does not need to be contained therein. Alternatively, the above-mentioned glass material may contain both magnesium oxide (MgO) and zinc oxide (ZnO).

In addition, the above-mentioned glass material may contain some kind of other components (accessory components) besides the above-mentioned components (principal components), unless it becomes the hindrance of an achievement of the objective of the present invention. For example, unless it becomes the hindrance of an achievement of the objective of the present invention, the above-mentioned glass material may contain a crystal nucleating agent (for instance, zirconium dioxide (ZrO₂), titanic oxide (TiO₂), platinum (Pt), diphosphorus pentaoxide (P₂O₅), etc.) etc. which is added in order to promote a crystallization of a glass phase, as an accessory component. Moreover, the above-mentioned glass material may further contain accessory components other than the above-mentioned principal component and accessory components, unless it becomes the hindrance of an achievement of the objective of the present invention (will be mentioned later in detail).

The above-mentioned glass phase can be obtained by melting various glass materials as mentioned above at a very high temperature (for instance, not less than 1200°C) and rapidly cooling the resulting melt (for example, by dropping it into water, etc.), for example. On the other hand, the crystalline phase, which is fired along with the glass phase thus obtained to constitute the glass-ceramics composites according to the present embodiment, comprises at least one sort of oxide system ceramics, as mentioned above. This crystalline phase corresponds to the filler particles dispersed in a glass-matrix in the glass-ceramics composites according to the above-mentioned conventional technology. These filler particles can contribute to an improvement of a thermal conductivity and an optimization of a heat expansion coefficient and an electric permittivity, etc. of a glass-ceramics composite, by being added and dispersed in the glass-matrix which constitutes the glass-ceramics composite, for example.

Although the oxide system ceramics contained in the above-mentioned crystalline phase is not limited in particular, as specific examples, for instance, alumina (Al₂O₃), copper oxide (CuO), mullite, magnesia (MgO), titania (TiO₂), zirconia (ZrO₂), silica glass (SiO₂), silica powder (SiO₂), cordierite (Mg₂Al₃ (AlSi₅O₁₈)), gahnite (ZnAl₂O₄), spinel (MgAl₂O₄), etc. can be exemplified. The above-mentioned crystalline phase may contain any one sort of these oxide system ceramics, or may contain two or more sorts of oxide system ceramics which are chosen from these oxide system ceramics. Moreover, the above-mentioned crystalline phase may further contain components (accessory components) other than the above-mentioned oxide system ceramics (principal component), unless it becomes the hindrance of an achievement of the objective of the present invention (will be mentioned later in detail).

Subsequently, the above-mentioned glass-ceramics composite can be obtained by mixing the above-mentioned glass phase and the above-mentioned crystalline phase at a desired combination ratio in powder form, for example, and firing the mixture at a predetermined temperature (for instance, 700 °C to 1150 °C). In addition, although the above-mentioned firing treatment is performed in an atmosphere in which inactive gas exists (for instance, a nitrogen atmosphere, etc.), for example, from a viewpoint of the prevention from a transmutation of filler particles, the above-mentioned firing treatment may be performed in an atmosphere in which oxygen exists (for instance, an air atmosphere, etc.) when oxide film suitable as an antioxidant membrane is easily formed on the surface of filler particles.

By the way, in the glass-ceramics composites according to the conventional technology, which is obtained by firing a glass phase obtained from glass material containing components as mentioned above and a crystalline phase, there is a problem that the thermal conductivity as the whole glass-ceramics composite becomes low since the thermal conductivity of the glass phase is low, as mentioned above. Moreover, as mentioned above, in the art, it has been proposed to attain a high thermal conductivity in a glass-ceramics composite by precipitating a celsian crystal which has a high aspect ratio from a glass phase (for instance, refer to the patent literature PTL 4). However, since a shape of crystal which precipitates from a glass phase is affected not only by a composition of glass, but also by a variety of factors, for example, such as a particle size of glass (particle size of the glass powder which is mixed and fired with ceramic particles (filler particles) to be a glass-ceramics composite) and firing conditions, it is thought that it is difficult to produce stably a glass-ceramics composite which has a high thermal conductivity by precipitating a celsian crystal having a high aspect ratio from a glass phase.

However, as mentioned above, the inventor has found that, in a glass-ceramics composite comprising a glass phase and a crystalline phase which contains an oxide system ceramics dispersed in the glass phase, the thermal conductivity of the glass-ceramics composite which is obtained by firing the glass phase and the crystalline phase can be raised by making the composition of material which forms the glass phase meet specific conditions.

Specifically, in a glass-ceramics composite according to the present embodiment, based on the total amount of glass material which forms a glass phase,
the combination ratio of silicon dioxide (SiO₂) is 45 mass % or more and 70 mass or less,
the combination ratio of aluminum oxide (Al₂O₃) is 16 mass % or more and 40 mass % or less, and
the combination ratio of magnesium oxide (MgO) is 14 mass % or more or the combination ratio of zinc oxide (ZnO) is more than 0 mass %, and both of the combination ratio of magnesium oxide (MgO) and the combination ratio of zinc oxide (ZnO) are 38 mass % or less.

In other words, in constituent material which originates in glass material among constituent materials of the glass-ceramics composite according to the present embodiment, the proportion of elements corresponding to silicon dioxide (SiO₂) is 45 mass % or more and 70 mass or less, and the proportion of elements corresponding to aluminum oxide (Al₂O₃) is 16 mass % or more and 40 mass % or less. Moreover, when the glass material which forms a glass phase contains magnesium oxide (MgO), the proportion of elements corresponding to magnesium oxide (MgO) in the constituent material originating in the glass material is 14 mass % or more and 38 mass % or less. On the other hand, when the glass material which forms a glass phase contains zinc oxide (ZnO), the proportion of elements corresponding to zinc oxide (ZnO) in the constituent material originating in the glass material is 0 mass % or more and 38 mass % or less. In addition, as mentioned above, in the constituent material originating in glass material, only either of magnesium oxide (MgO) and zinc oxide (ZnO) may be contained, or both of these may be contained.

In the glass-ceramics composite according to the present embodiment, the composition of the glass material which forms the glass phase satisfies the above-mentioned conditions and, thereby, the thermal conductivity of the glass-ceramics composite which is obtained by firing the glass phase and the crystalline phase can be raised.

In addition, it is not desirable that the combination ratio of silicon dioxide (SiO₂) based on the total amount of glass material (namely, the proportion of elements corresponding to silicon dioxide (SiO₂) in constituent material which originates in glass material among constituent materials of the glass-ceramics composite according to the present embodiment) is less than 45 mass %, since it may become difficult to sufficiently reduce an electric permittivity and a thermal conductivity of a glass phase and it may become difficult to use the composite in a use such as a circuit board, etc. On the contrary, it is not desirable that the combination ratio of silicon dioxide (SiO₂) based on the total amount of glass material is more than 70 mass %, since it will become difficult to fire with a crystalline phase.

Moreover, it is not desirable that the combination ratio of aluminum oxide (Al₂O₃) based on the total amount of glass material (namely, the proportion of elements corresponding to aluminum oxide (Al₂O₃) in constituent material which originates in glass material among constituent materials of the glass-ceramics composite according to the present embodiment) is less than 16 mass %, since the thermal conductivity of the resulting glass-ceramics composite falls. More preferably, it is desirable that the combination ratio of aluminum oxide (Al₂O₃) based on the total amount of glass material is 20 mass % or more. On the contrary, it is not desirable that the combination ratio of aluminum oxide (Al₂O₃) based on the total amount of glass material is more than 40 mass %, since it will become difficult to melt the glass material and it becomes difficult to vitrify the same.

Furthermore, as mentioned above, as for magnesium oxide (MgO) and zinc oxide (ZnO), at least either one of these components should be blended as a constituent of a glass phase at a predetermined combination ratio respectively. Specifically, as for magnesium oxide (MgO) and zinc oxide (ZnO), both of condition (I) and condition (II) listed below must be satisfied.

Condition (I): The combination ratio of magnesium oxide (MgO) based on the total amount of a glass material(namely, the proportion of elements corresponding to magnesium oxide (MgO) in a constituent material which originates in the above-mentioned glass material among constituent materials of the glass-ceramics composite according to the present embodiment) is 14 mass % or more (more preferably, 17 mass % or more), or the combination ratio of zinc oxide (ZnO) based on the total amount of the glass material (namely, the proportion of elements corresponding to zinc oxide (ZnO) in a constituent material which originates in the above-mentioned glass material among the constituent materials of the glass-ceramics composite according to the present embodiment) is more then 0 mass %.

Condition (II): The combination ratio of magnesium oxide (MgO) is 38 mass % or less, and the combination ratio of zinc oxide (ZnO) is 38 mass % or less (more preferably, 19 mass % or less) based on the total amount of the glass material.

As a matter of course, both magnesium oxide (MgO) and zinc oxide (ZnO) may be blended as components of a glass phase, wherein the combination ratio of magnesium oxide (MgO) based on the total amount of a glass material is 14 mass % or more (more preferably, 17 mass % or more) and 38 mass % or less and, in addition, the combination ratio of zinc oxide (ZnO) based on the total amount of the glass material is more than 0 mass % and 38 mass % or less (more preferably, 19 mass % or less).

It is not desirable that the combination ratio of magnesium oxide (MgO) based on the total amount of a glass material is less than 14 mass % and the combination ratio of zinc oxide (ZnO) based on the total amount of the glass material is the 0 mass % (namely, zinc oxide (ZnO) is not blended as a constituent of a glass phase), since the thermal conductivity of the resulting glass-ceramics composite obtained falls. It is presumed that this is because a sufficient quantity of a spinel system chemical compound crystalline phase which has a higher thermal conductivity as compared with a glass phase (specifically, gahnite (ZnAl₂O₄)) cannot be precipitated when magnesium oxide (MgO) does not exist in a glass phase in a predetermined quantity or more, and a sufficient quantity of a spinel system chemical compound crystalline phase which has a higher thermal conductivity as compared with a glass phase (specifically, spinel (MgAl₂O₄)) cannot be precipitated when zinc oxide (ZnO) does not exist in a glass phase.

On the contrary, it is not desirable that the combination rate of either one of magnesium oxide (MgO) or zinc oxide (ZnO) is more than 40 mass % based on the total amount of a glass phase, since it becomes difficult to melt the glass material and it becomes difficult to vitrify the same.

On the other hand, the glass-ceramics composite according to the present embodiment is a glass-ceramics composite which is obtained by firing a glass phase as mentioned above and a crystalline phase containing at least one sort of oxide system ceramics, as mentioned above. Namely, the oxide system ceramics contained in a crystalline phase may be one sort of oxide system ceramics, or may be the combination of a plurality of sorts (two or more kinds) of oxide system ceramics. Moreover, when a crystalline phase comprises the combination of a plurality of sorts (two or more kinds) of oxide system ceramics, the combination ratio of these two or more sorts of oxide system ceramics can be suitably determined, for instance, in accordance with values of a thermal conductivity, a heat expansion coefficient and an electric permittivity, and a compactness, etc., to be attained in the glass-ceramics composite.

By the way, as mentioned above, among the glass phase and the crystalline phase which constitute the glass-ceramics composite according to the present embodiment, the crystalline phase corresponds to filler particles dispersed in a glass-matrix in the glass-ceramics composites according to the above-mentioned conventional technology. Such filler particles can contribute to an improvement of a thermal conductivity and an optimization of a heat expansion coefficient and a permittivity, etc. of a glass-ceramics composite, by being added and dispersed in the glass-matrix which constitutes the glass-ceramics composite, for example. Therefore, a suitable combination ratio of the crystalline phase based on the total amount of the glass-ceramics composite (namely, the amount of sum totals of a glass phase and a crystalline phase) can be suitably determined, for instance, in accordance with values of a thermal conductivity, a heat expansion coefficient and an electric permittivity, and a compactness, etc., to be attained in the glass-ceramics composite. Typically, however, in the glass-ceramics composite according to the present embodiment, it is desirable that the combination ratio of the crystalline phase based on the amount of sum totals of the glass phase and the crystalline phase is 5 mass % or more and less than 50 mass %.

It is not desirable that the combination ratio of the crystalline phase based on the total amount of a glass-ceramics composite (namely, the amount of sum totals of a glass phase and a crystalline phase) is less than 5 mass %, since it becomes difficult to acquire the effect by addition of a crystalline phase (filler particles) in the resulting glass-ceramics composite. More preferably, it is desirable that the combination ratio of the crystalline phase based on the total amount of the glass-ceramics composite is 20 mass % or more. On the contrary, it is not desirable that the combination ratio of the crystalline phase based on the total amount of the glass-ceramics composite is 50 mass % or more, since it becomes difficult to sufficiently densify (raise the compactness of) the mixture of a crystalline phase (filler particles) and a glass phase by firing. In addition, in the present specification, "densification" means that water absorption becomes smaller by reduction of void in a glass-ceramics composite, etc., for example. In addition, when water absorption is high, the moisture resistance of a glass ceramic composite, etc. will fall, for example.

By the way, as mentioned above, the above-mentioned crystalline phase (filler particles) may further contain components (accessory components) other than the above-mentioned oxide system ceramics (principal component), unless it becomes the hindrance of an achievement of the objective of the present invention. As mentioned above, filler particles can contribute to an improvement of a thermal conductivity and an optimization of a heat expansion coefficient and an electric permittivity, etc. of a glass-ceramics composite, by being added and dispersed in a glass-matrix which constitutes the glass-ceramics composite, for example.

In addition, it is known that, among various sorts of filler particles, some sorts of filler particles can contribute to effects other than the above by being added and dispersed in a glass-matrix which constitutes a glass-ceramics composite. For instance, oxide system fillers, such as titania (TiO₂), zirconia (ZrO₂), cordierite (Mg₂Al₃(AlSi₅O₁₈)) and spinel (MgAl₂O₄), and non-oxide system fillers, such as silicon carbide (SiC) and silicon nitride (Si₃N₄), have effects which promote or stabilize a precipitation of the crystalline phase from the glass phase. Especially, silicon carbide (SiC) is suitable, since it has a high thermal conductivity as filler particles and a large effect which promotes or stabilizes a precipitation of the crystalline phase from the glass phase. Moreover, non-oxide system fillers, such as aluminum nitride (AIN), silicon carbide (SiC) and silicon nitride (Si₃N₄), can contribute to an improvement of a thermal conductivity of a glass-ceramics composite. Accordingly, unless it becomes a hindrance of an achievement of the objective of the present invention, the above-mentioned filler particles as a principal component and filler particles as an accessory component which is suitably chosen from these filler particles can be used in combination at any given combination ratio to acquire a desired effect among various effects as mentioned above.

As mentioned above, in accordance with the present embodiment, in a glass-ceramics composite comprising a glass phase and a crystalline phase which contains an oxide system ceramics dispersed in the glass phase, by making the composition of material which forms the glass phase meet specific conditions, the thermal conductivity of the glass-ceramics composite which is obtained by firing the glass phase and the crystalline phase can be raised.

By the way, in the glass-ceramics composites used as LTCC, it is considered to be important to lower the melting point and/or softening point of a glass phase, for example, from a viewpoint of securing the property required for LTCC, such as an improvement of workability at the time of melting a glass phase, a reduction of a firing temperature, and an improvement of strength and a thermal conductivity by raising its compactness. In order to lower the melting point of a glass phase, it is effective to add a flux component, such as boron oxide (B₂O₃), to a glass phase, for example. However, a glass phase containing a large amount of boron oxide (B₂O₃) is less moisture-resistant, and concern remains about reliability under a high-temperature and high-humidity environment, for example, when a glass-ceramics composite comprising such a glass phase is used, for example, as a material for a substrate (electronic circuit board) on which an electronic-circuit element is mounted.

Therefore, the second embodiment of the present invention is,
a glass-ceramics composite according to the first embodiment of the present invention, wherein:
said glass material further contains boron oxide (B₂O₃), and
the combination ratio of boron oxide (B₂O₃) based on the total amount of said glass material is more than 0 mass % and 20 mass % or less.

As mentioned above, in the glass-ceramics composite according to the present embodiment, said glass material further contains boron oxide (B₂O₃), and the combination ratio of boron oxide (B₂O₃) based on the total amount of said glass material is more than 0 mass % and 20 mass % or less. Thus, in the glass-ceramics composite according to the present embodiment, the glass material further contains boron oxide (B₂O₃) and, thereby, the melting point of a glass phase can be lowered, and properties required for LTCC, such as an improvement of workability at the time of melting a glass phase, a reduction of a firing temperature, and an improvement of strength and a thermal conductivity by raising its compactness, can be secured, as mentioned above.

On the other hand, in the glass-ceramics composite according to the present embodiment, the combination ratio of boron oxide (B₂O₃) based on the total amount of the glass material is limited to be 20 mass % or less. Thereby, in the glass-ceramics composite according to the present embodiment, the moisture resistance of the glass phase can be maintained sufficiently. In other words, when the combination ratio of boron oxide (B₂O₃) based on the total amount of the glass material is more than 20 mass %, the moisture resistance of the glass phase falls, and its reliability under a high-temperature and high-humidity environment becomes more likely to fall when a glass-ceramics composite comprising such a glass phase is used as a material for a substrate (electronic circuit board) on which an electronic-circuit element is mounted, for example. More preferably, it is desirable that the combination ratio of boron oxide (B₂O₃) based on the total amount of the glass material which form the glass phase which constitutes the glass-ceramics composite according to the present embodiment is 9 mass % or less.

In addition, as mentioned above, boron oxide (B₂O₃) contained in the glass material which forms a glass phase in the glass-ceramics composite according to the present embodiment is a "flux component" which is added in order to adjust the melting behavior at the time of melting the glass material at a high temperature in a process in which a glass phase is generated. Unless it becomes the hindrance of an achievement of the objective of the present invention, such a flux component may contain, in addition to boron oxide (B₂O₃), alkali metal oxides (for instance, lithium oxide (Li₂O), sodium oxide (Na₂O), potassium oxide (K₂O), etc.), etc.

By the way, as mentioned above, in the art, in glass-ceramics composites, it has been proposed to attain a high thermal conductivity by precipitating a crystal of celsian (BaAl₂Si₂O₈) which has a high aspect ratio from a glass phase. Barium oxide (BaO) which is a constituent of this celsian may be contained in the glass material which forms the glass phase constituting the glass-ceramics composite according to the present invention. However, as mentioned above, since a shape of a crystal which precipitates from a glass phase is likely to be affected not only by a composition of glass, but also by a variety of factors, it is difficult to produce stably a glass-ceramics composite which comprises a glass phase containing celsian crystals in a quantity sufficient for attaining a desired thermal conductivity. In other words, unless various factors affecting the shape of a crystal which precipitates from a glass phase are strictly controlled, there is a possibility that the existing amount of celsian crystals with a high aspect ratio in a glass phase may change and, as a result, the thermal conductivity of the glass-ceramics composite comprising such a glass phase may become unintended.

Therefore, the third embodiment of the present invention is,
a glass-ceramics composite according to said first or second embodiment of the present invention, wherein:
said glass material further contains barium oxide (BaO), and
the combination ratio of barium oxide (BaO) based on the total amount of said glass material is more than 0 mass % and less than 10 mass %.

As mentioned above, in the glass-ceramics composite according to the present embodiment, said glass material further contains barium oxide (BaO), and the combination ratio of barium oxide (BaO) based on the total amount of said glass material is 0 mass % or more and less than 10 mass %. Thus, in the glass-ceramics composite according to the present embodiment, although the glass material further contains barium oxide (BaO), the combination ratio of barium oxide (BaO) based on the total amount of the glass material is restricted to be 0 mass % or more and less than 10 mass %. Thereby, in the glass-ceramics composite according to the present embodiment, the possibility that a celsian crystal which has a high aspect ratio may precipitate is reduced, and unintended change of the thermal conductivity of the glass-ceramics composite comprising such a glass phase is reduced. More preferably, it is desirable that the combination ratio of barium oxide (BaO) based on the total amount of the glass material which forms the glass phase constituting the glass-ceramics composite according to the present embodiment is less than 9 mass %.

By the way, as mentioned above, in the crystalline phase (filler particles) which constitutes the glass-ceramics composites according to the present invention, unless it becomes a hindrance of an achievement of the objective of the present invention, the above-mentioned filler particles as a principal component and filler particles as an accessory component which is suitably chosen from these filler particles can be used in combination at any given combination ratio to acquire a desired effect among various effects as mentioned above. Namely, the crystalline phase (filler particles) which constitutes the glass-ceramics composite according to the present invention may also contain a non-oxide system ceramics as mentioned above in addition to an oxide system ceramics as mentioned above. However, generally, in many cases, a non-oxide system ceramics is more difficult to be obtained, or its selling price is higher, as compared with an oxide system ceramics. Accordingly, it is desirable that the proportion of the non-oxide system ceramics based on the crystalline phase (filler particles) which constitutes the glass-ceramics composites according to the present invention is restricted to the minimum necessary, from a viewpoint of securing productivity and saving its manufacturing-cost.

Therefore, the fourth embodiment of the present invention is,
a glass-ceramics composite according to any one of said first to third embodiments of the present invention, wherein:
said crystalline phase further contains at least one sort of non-oxide system ceramics, and
the combination ratio of said at least one sort of non-oxide system ceramics based on the amount of sum totals of said glass phase and said crystalline phase is more than 0 mass % and less than 20 mass %.

As mentioned above, in the glass-ceramics composite according to the present embodiment, the above-mentioned crystalline phase further contains at least one sort of non-oxide system ceramics. Thereby, in the glass-ceramics composite according to the present embodiment, as mentioned above, unless it becomes the hindrance of an achievement of the objective of the present invention, at least one sort of oxide system ceramics (oxide system filler particles) as the above-mentioned principal component and filler particles as an accessory component which is suitably chosen from at least on sort of these non-oxide system ceramics (non-oxide system filler particles) can be used in combination at any given combination ratio to acquire a desired effect among various effects, such as an improvement of a thermal conductivity, an optimization of a heat expansion coefficient and an electric permittivity, and a promotion and stabilization of a precipitation of a crystalline phase from a glass phase, for example.

However, as mentioned above, generally, in many cases, a non-oxide system ceramics is more difficult to be obtained, or its selling price is higher, as compared with an oxide system ceramics. Accordingly, it is desirable that the proportion of the non-oxide system ceramics based on the crystalline phase (filler particles) which constitutes the glass-ceramics composites according to the present invention is restricted to the minimum necessary, from a viewpoint of securing productivity and saving its manufacturing-cost. Then, in the glass-ceramics composite according to the present embodiment, as mentioned above, the combination ratio of said at least one sort of non-oxide system ceramics based on the amount of sum totals of said glass phase and said crystalline phase is more than 0 mass % and less than 20 mass %. Thereby, in the glass-ceramics composite according to the present embodiment, by concomitantly using oxide system filler particles and non-oxide system filler particles as mentioned above, a desired effect among various effects, such as an improvement of a thermal conductivity, an optimization of a heat expansion coefficient and an electric permittivity, and a promotion and stabilization of a precipitation of a crystalline phase from a glass phase, for example, can be acquired, as well as its productivity can be secured and its manufacturing-cost can be saved.

Hereafter, configurations and characteristics, etc. of glass-ceramics composites according to some embodiments of the present invention will be explained in more detail. However, the explanation that will be mentioned below is intended absolutely for exemplification, and it should not be interpreted that the scope of the present invention is limited to the following explanation.

### [Example]

### (1) Preparation of Samples for Evaluation

Glass-ceramics composites which have various compositions listed in Table 1 were prepared as samples for evaluation (test pieces). Broadly, samples for evaluation where the combination ratios of all the constituents are within a range desirable as a glass-ceramics composite according to the present invention are classified as Working Examples (E01 to E23), and samples for evaluation where the combination ratios of any of the constituents deviates from a range desirable as a glass-ceramics composite according to the present invention are classified as Comparative Examples (C01 to C11).

More particularly, first, raw materials of various constituents which constitute a glass phase (glass material) were blended, molten by a heat-treatment for 2 hours at a predetermined temperature (specifically, 1550 °C) under an air atmosphere using a pot made of platinum, and the molten glass was rapidly cooled by being poured into water. Thereby, a glass phase was generated. On this occasion, a vitrification is difficult and a glass phase could not be generated normally, as for Comparative Examples (respectively, C05, C08 and C09) where the combination ratios of aluminum oxide (Al₂O₃), magnesium oxide (MgO), and silicon dioxide (SiO₂) are excessive, respectively.

Next, various glass phases obtained as mentioned above were respectively wet-milled into powder, and their particle sizes were adjusted. These powders of the glass phases thus obtained were mixed with filler particles as crystalline phases (alumina (Al₂O₃) by itself, or a mixture of alumina (Al₂O₃) with cordierite (Mg₂Al₃(AlSi₅O₁₈)) and/or aluminum nitride (AIN)) at the combination ratios shown in Table 1, and each mixture was pressed by dry pressing to a pellet-shape with a diameter of 20 mm and a width of 5 mm, and fired for 5 hours at a predetermined temperature (specifically, 700 °C to 1150 °C) under a nitrogen atmosphere. Thereby, various samples for evaluation were prepared. These firing temperatures are lower than a firing temperature of alumina substrates, and it means that co-firing with good conductor with a low melting point, such as gold (Au), silver (Ag), copper (Cu), and alloys containing any of these metals (for instance, silver-palladium (Ag/Pd), etc.) became possible, for example. In addition, as a matter of course, as for the Comparative Examples C05, C08 and C09 which were difficult to vitrify, no sample for evaluation (test piece) could be prepared.

### (2) Evaluation Method of Samples for Evaluation

Various characteristics described below were analyzed, as for each of the various samples for evaluation (test pieces) obtained as mentioned above.

### a) Compactness

As for each of the various samples for evaluation (test pieces) obtained as mentioned above, compactness was evaluated. A "red-check method" which is one of the methods widely used for detecting a fine defect opening on the material surface was adopted. In the present example, the various samples for evaluation (fired objects) were immersed in a solution containing dyestuff, and the solution adhering to the surface of the fired objects was wiped off, and further the solution was removed by water-washing, etc. Thereafter, based on whether the fired object has been dyed by the dyestuff or not, the quality of compactness was judged. As mentioned above, a glass-ceramics composites (fired object), which has been sufficiently densified, has few voids, and should not be easily dyed with dyestuff. Therefore, in the present example, as for a fired object which was dyed with dyestuff, its compactness is judged as poor.

### b) Thermal Conductivity

As for each of the various samples for evaluation (test pieces) obtained as mentioned above, thermal conductivity was measured. A "laser flash method" which is a typical method of non-steady method was adopted as a method for measurement of the thermal conductivity. In addition, since details of the "laser flash method" are well-known to a person skilled in the art, an explanation is omitted here. However, the thermal conductivities listed in Table 1 were acquired by multiplying the thermal diffusivity measured through the "laser flash method" by the specific heat and density of the various samples for evaluation.

The evaluation results of the above-mentioned a) and b) are listed in the following Table 1, along with the compositions of respective samples for evaluation.

[Table 1]

**Table 1**

| | Glass Phase Composition [mass%] | | | | | | | | Composite Comp. [mass%] | | | | Compactness | TC *b |
|---|---|---|---|---|---|---|---|---|---|---|---|---|---|---|
| | Al₂O₃ | MgO | ZnO | SiO₂ | B₂O₃ | Li₂O | Na₂O | K₂O | Glass | Alumina | Cordierite | AIN | | |
| E01 | 30 | 20 | | 45 | 5 | | | | 80 | 20 | | | Good | 6 |
| E02 | 30 | 20 | | 45 | 5 | | | | 90 | 10 | | | Good | 5.5 |
| E03 | 30 | 20 | | 45 | 5 | | | | 50.5 | 49.5 | | | Good | 7 |
| E04 | 30 | 20 | | 45 | 1 | 2 | 2 | | 50.5 | 49.5 | | | Good | 7 |
| E05 | 30 | 20 | | 45 | 1 | 2 | 2 | | 51 | 49 | | | Good | 9 |
| E06 | 30 | 20 | | 45 | 5 | | | | 50.5 | 39.5 | 10 | | Good | 7 |
| E07 | 30 | 20 | | 45 | 5 | | | | 50.5 | 29.5 | 20 | | Good | 6 |
| E08 | 30 | 20 | | 45 | 5 | | | | 50.5 | 20 | 10 | 19.5 | Good | 9 |
| E09 | 30 | 20 | | 45 | 5 | | | | 51 | 30 | | 19 | Good | 9 |
| E10 | 16 | 25 | | 57 | 2 | | | | 50.5 | 49.5 | | | Good | 7 |
| E11 | 20 | 25 | | 53 | 2 | | | | 50.5 | 49.5 | | | Good | 7 |
| E12 | 38 | 14 | | 45 | 3 | | | | 70 | 30 | | | Good | 6 |
| E13 | 30 | 14 | | 52 | 4 | | | | 50.5 | 49.5 | | | Good | 7 |
| E14 | 30 | 17 | | 49 | 4 | | | | 50.5 | 49.5 | | | Good | 8 |
| E15 | 16 | 35 | | 45 | 4 | | | | 80 | 20 | | | Good | 6 |
| E16 | 16 | 17 | | 63 | 4 | | | | 70 | 30 | | | Good | 6 |
| E17 | 16 | | 5 | 70 | 9 | | | | 80 | 20 | | | Good | 6 |
| E18 | 30 | 12 | 3 | 50 | 5 | | | | 55 | 45 | | | Good | 7 |
| E19 | 30 | 20 | | 50 | | | | | 70 | 30 | | | Good | 6 |
| E20 | 16 | | 30 | 45 | 9 | | | | 70 | 30 | | | Good | 6 |
| E21 | 30 | 17 | | 49 | 2 | | | 2 | 65 | 35 | | | Good | 7 |
| E22 | 23 | 17 | | 45 | 14 | | | 1 | 65 | 35 | | | Good | 6 |
| E23 | 16 | 4 | 15 | 45 | 20 | | | | 65 | 35 | | | Good | 6 |
| C01 | 30 | 20 | | 45 | 5 | | | | 50 | 50 | | | Poor | *c |
| C02 | 30 | 20 | | 45 | 5 | | | | 40 | 60 | | | Poor | *c |
| C03 | 16 | 25 | | 57 | 2 | | | | 50 | 50 | | | Poor | *c |
| C04 | 20 | 25 | | 53 | 2 | | | | 50 | 50 | | | Poor | *c |
| C05 | 41 | 14 | | 45 | | | | | *a | *a | | | *c | *c |
| C06 | 30 | 14 | | 52 | 4 | | | | 50 | 50 | | | Poor | *c |
| C07 | 30 | 17 | | 49 | 4 | | | | 50 | 50 | | | Poor | *c |
| C08 | 16 | 39 | | 45 | | | | | *a | *a | | | *c | *c |
| C09 | 16 | | 5 | 73 | 6 | | | | *a | *a | | | *c | *c |
| C10 | 12 | 25 | | 57 | 4 | | 2 | | 55 | 45 | | | Good | 4 |
| C11 | 25 | 12 | | 57 | 4 | | 2 | | 55 | 45 | | | Good | 4 |

| | | | | | | | | | | | | | | |
|---|---|---|---|---|---|---|---|---|---|---|---|---|---|---|
| *a: Difficult to vitrify, *2: TC=Thermal Conductivity [W/(°C•m)], *c: not measured. | | | | | | | | | | | | | | |

### (3) Evaluation Results of Samples for Evaluation

As shown in Table 1, the samples for evaluation where the combination ratios of all the constituents were within a range desirable as a glass-ceramics composite according to the present invention (Working Examples E01 to E21) were sufficiently densified and could attain higher thermal conductivities as compared with Comparative Examples. Namely, it was confirmed that, by bringing the combination ratio of all the constituents within a range desirable as a glass-ceramics composite according to the present invention, a glass-ceramics composite which is suitable for a low-temperature firing use and has a high thermal conductivity can be provided.

On the other hand, as for the samples for evaluation where the combination ratio of the crystalline phase (filler particles) in a glass-ceramics composite is excessive (Comparative Examples C01 to C04, C06 and C07), since it was not densified sufficiently as a glass-ceramics composite, its thermal-conductivity was not measured. In a glass-ceramics composite with thus insufficient densification, low moisture resistance is a concern, for example. In the sample for evaluation where the combination ratio of aluminum oxide (Al₂O₃) in a glass phase is too little (Comparative Examples C10) and the sample for evaluation where the combination ratio of magnesium oxide (MgO) is too little and the combination ratio of zinc oxide (ZnO) is 0 mass % (namely, zinc oxide (ZnO) is not blended as a constituent of a glass phase), in a glass phase (Comparative Examples C11), sufficient thermal conductivity could not be attained.

As mentioned above, although some embodiments which have specific configurations have been explained for the purpose of explaining the present invention, the scope of the present invention is not limited to these exemplary embodiments, and it is needless to say that any modifications can be added suitably within the limits of the matter described in the claims and the specification.

## Claims

1. A glass-ceramics composite, which is obtained by firing;
a glass phase obtained from a glass material containing silicon dioxide (SiO₂), aluminum oxide (Al₂O₃) and at least one of magnesium oxide (MgO) or zinc oxide (ZnO), and
a crystalline phase containing at least one sort of oxide system ceramics, wherein:
based on the total amount of said glass material,
the combination ratio of silicon dioxide (SiO₂) is 45 mass % or more and 70 mass % or less,
the combination ratio of aluminum oxide (Al₂O₃) is 16 mass % or more and 40 mass % or less, and
the combination ratio of magnesium oxide (MgO) is 14 mass % or more or the combination ratio of zinc oxide (ZnO) is more than 0 mass %, and both of the combination ratio of magnesium oxide (MgO) and the combination ratio of zinc oxide (ZnO) are 38 mass % or less, and
based on the amount of sum totals of said glass phase and said crystalline phase,
the combination ratio of said crystalline phase is 5 mass % or more and less than 50 mass %.

2. A glass-ceramics composite according to Claim 1, wherein:
said glass material further contains boron oxide (B₂O₃), and
the combination ratio of boron oxide (B₂O₃) based on the total amount of said glass material is more than 0 mass % and 20 mass % or less.

3. A glass-ceramics composite according to Claim 1 or 2, wherein:
said glass material further contains barium oxide (BaO), and
the combination ratio of barium oxide (BaO) based on the total amount of said glass material is more than 0 mass % and less than 10 mass %.

4. A glass-ceramics composite according to any one of Claims 1 to 3, wherein:
said crystalline phase further contains at least one sort of non-oxide system ceramics, and
the combination ratio of said at least one sort of non-oxide system ceramics based on the amount of sum totals of said glass phase and said crystalline phase is more than 0 mass % and less than 20 mass %.
